# EUROPÄISCHE PATENTSCHRIFT

(11) **EP 2 851 692 B1**
(45) Veröffentlichungstag und Bekanntmachung des Hinweises auf die Patenterteilung: **12.06.2019**
(21) Anmeldenummer: 14177467.9
(22) Anmeldetag: 17.07.2014
(51) Int. Cl.: G01R 27/18, H02H 3/17, G01R 31/14, H02H 3/33, G01R 31/08, H02H 7/26

(54) **Isolationsfehlersuchsystem mit zweigselektiver Einspeisung und selektives Isolationsüberwachungssystem sowie Verfahren zur Bestimmung einer Querverbindungsimpedanz zwischen zwei Subsystemen**
Insulation error detection system with branch-selective feed-in and selective isolation monitoring system, and method for determining a cross-link impedance between two subsystems
Système de recherche de défaut d'isolation doté d'une alimentation à sélection de branchement et système de surveillance d'isolation sélectif ainsi que procédé de détermination d'une impédance de ligne inter-automatique entre deux sous-systèmes

(30) Priorität: 19.09.2013 DE 102013218836
(43) Veröffentlichungstag der Anmeldung: 25.03.2015
(73) Patentinhaber: Bender GmbH & Co. KG, 35305 Grünberg (DE)
(72) Erfinder: Hackl, Dipl.-Ing. Dieter, 35463 Fernwald (DE)
(74) Vertreter: advotec.

(56) Entgegenhaltungen:
- EP-A1- 1 936 393
- EP-A1- 2 530 801
- WO-A1-2010/069739
- DE-A1- 1 945 803
- DE-A1-102010 011 476
- DE-B3-102004 018 918
- BALDWIN T ET AL: "Analysis of fault locating signals for high-impedance grounded systems", CONFERENCE RECORD OF THE 2001 IEEE INDUSTRY APPLICATIONS CONFERENCE. 36TH IAS ANNUAL MEETING . CHICAGO, IL, SEPT. 30 - OCT. 4, 2001; [CONFERENCE RECORD OF THE IEEE INDUSTRY APPLICATIONS CONFERENCE. IAS ANNUAL MEETING], NEW YORK, NY : IEEE, US, Bd. 3, 30. September 2001 (2001-09-30), Seiten 1823-1830, XP010561937, DOI: 10.1109/IAS.2001.955779 ISBN: 978-0-7803-7114-9

## Beschreibung

Die Erfindung betrifft ein Isolationsfehlersuchsystem für ein verzweigtes IT-System mit einem Subsystem (Subnetz) und mit einer in dem Subsystem angeordneten Differenzstrommesseinrichtung zur Erfassung eines Differenzstrom-Messsignals. Des Weiteren umfasst die Erfindung ein Isolationsüberwachungssystem zur Überwachung eines Isolationswiderstandes in einem verzweigten IT-System mit einem Subsystem und mit den Merkmalen des Isolationsfehlersuchsystems sowie ein Verfahren zur Bestimmung einer Querverbindungsimpedanz zwischen zwei Subsystemen in einem verzweigten IT-System mit dem erfindungsgemäßen Isolationsüberwachungssystem.

Um eine hohe Verfügbarkeit und Betriebssicherheit der elektrischen Stromversorgung sicherzustellen sowie die Personensicherheit im Aufenthaltsbereich elektrischer Anlagen zu gewährleisten, kommen in zunehmendem Maße Stromversorgungsnetze zum Einsatz, deren aktive Teile von dem Erdpotential getrennt sind. Bei dieser als IT-System bezeichneten Art des Stromversorgungsnetzes kann ein aktiver Leiter einen Isolationsfehler aufweisen, ohne dass der laufende Betrieb der Anlage unterbrochen werden muss, weil sich wegen des im Idealfall unendlich großen Impedanzwertes zwischen Leiter und Erde in diesem ersten Fehlerfall kein geschlossener Stromkreis ausbilden kann. Als Isolationsfehler wird dabei ein fehlerhafter Zustand des IT-Systems verstanden, der zum Absinken des Isolationswiderstands unter das zulässige Isolationsniveau führt. Aus dieser Betrachtung geht hervor, dass der Widerstand in dem zu überwachenden Netz gegen Erde (Isolationswiderstand - im Fehlerfall auch Fehlerwiderstand) ständig überwacht werden muss, da durch einen möglichen weiteren Fehler an einem anderen aktiven Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte. Aus dem Stand der Technik bekannte aktiv messende Isolationsüberwachungsgeräte werden in dem Hauptzweig des IT-Systems zwischen den Netzleitern und Erde angeschlossen und überlagern dem Netz eine Messspannung, die zu einem dem Isolationswiderstand proportionalen Stromfluss führt. Dieser Messstrom verursacht an dem Messwiderstand des Isolationsüberwachungsgerätes einen Spannungsabfall, der ausgewertet wird und bei Überschreiten eines voreinstellbaren Grenzwertes eine Warnmeldung zur Folge hat.

Auf dem Gebiet der Isolationswiderstandsmessung und der Erkennung von Erdschlüssen sind unterschiedliche Verfahren bekannt.

So zeigt die EP 2 530 801 A1 ein Fehlerstrom-Schutzsystem zur störresistenten Bestimmung des Erdschluss-Fehlerwiderstands in durch Systemrauschen beeinträchtigten elektrischen Anlagen, insbesondere für dreiphasige elektrische Maschinen. Das Messverfahren beruht auf der Einspeisung einer Messsignalspannung, deren Frequenz adaptiv in Abhängigkeit eines gemessenen Rauschspektrums eingestellt wird.

Aus der DE 1 945 803 A1 ist eine Schaltungsanordnung zur Überwachung des Isolationswiderstands gegen Erde bei einem Läuferkreis von Gleichstrommaschinen bekannt. Die Schaltungsanordnung basiert auf dem Vergleich von durch eine Hilfswechselspannung U hervorgerufenen Strömen mit im Läuferkreis verursachten Strömen, um einen unzulässigen Isolationswiderstand zu erkennen. Zur Auskopplung der im Läuferkreis entstehenden Ströme ist ein auf die Frequenz der Hilfswechselspannung abgestimmter Bandpass B vorgesehen.

In der EP 1 936 393 A1 sind eine Anordnung und ein Verfahren zur Bestimmung der Impedanz eines elektrischen Gerätes offenbart. Um gleichzeitig mehrere Impedanzmessungen bei verschiedenen Frequenzen vornehmen zu können, werden zwei Messsignale mit jeweils unterschied licher Frequenz überlagert und das sich ergebende Impedanzspektrum ausgewertet. Das Verfahren kann zur Erkennung eines Erdschlussfehlers, beispielsweise bei einem 3-phasigen elektrischen Generator, angewendet werden.

Die WO 2010/069739 A1 zeigt ein System zur redundanten Erkennung eines Erdschlussfehlers bei einem elektrischen Generator. Dazu werden zwei Testsignale mit unterschiedlichen, von der Netzfrequenz abweichenden Frequenzen in den Schaltkreis des Generators eingespeist und die auf Basis des jeweiligen Testsignals bestimmten elektrischen Parameter (Impedanzen) miteinander verglichen. Sollten die ermittelten Ergebnisse stark voneinander abweichen, wird zusätzlich eine Alarmmeldung ausgegeben.

DE102004018918 offenbart ein Isolationsfehlerortungssystem mit zentraler Einspeisung des Prüfsignals
DE2010011476 offenbart ein System zur Überprüfung von Fotovoltaikanlagen, wobei ein zentraler Testpuls nacheinander auf isolierte Teilanlagen gegeben wird.

Einhergehend mit der ständigen Isolationsüberwachung ist eine schnell und zuverlässig durchführbare Lokalisierung und Beseitigung des Isolationsfehlers (Isolationsfehlersuche) unerlässlich.

Tritt in einem IT-System ein Isolationsfehler auf, wird dieser von einem Isolationsüberwachungsgerät erkannt und gemeldet. Mit dieser Meldung startet die Isolationsfehlersuche, indem ein Prüfsignalgenerator ein Prüfsignal (Prüfstrom) erzeugt und dieses dem Stand der Technik gemäß an zentraler Stelle im Hauptzweig in das Stromversorgungssystem einspeist. Der Prüfstrom fließt dabei über die spannungsführenden Leitungen, den Fehlerwiderstand und die Erdleitung zu dem Prüfstromeinspeisepunkt zurück. Dieses Prüfstromsignal kann von allen Messstromwandlern, die in diesem Stromkreis liegen, erfasst werden.

Das Ziel bei dem Einsatz eines Isolationsfehlersuchsystems in verzweigten IT-Systemen besteht in der möglichst empfindlichen Detektion vorhandener Isolationsfehler in den Subsystemen und in der Bestimmung des Subsystems mit dem größten Isolationsfehler, also dem kleinsten Isolationsfehlerwiderstand. Da der Prüfsignalgenerator praktisch immer strombegrenzt ausgeführt wird, erfolgt eine Stromteilung des Prüfstromes zwischen allen im IT-System vorhandenen Isolationsfehlerwiderständen und Netzableitkapazitäten. Der in einem Subnetz fließende Fehlerstrom ist also nicht nur abhängig von der Größe des Fehlerwiderstandes in diesem Subnetz, sondern auch von weiteren im IT-System vorhandenen Fehlerwiderständen und Netzableitkapazitäten. Die jeweilige Differenzstrommesseinrichtung in dem Subnetz kann erst ab einem von der Auflösung und dem Messfehler des Messsystems bestimmten minimalen Differenzstrom Isolationsfehler im zu überwachenden Subnetz sicher detektieren. Daher wird die Empfindlichkeit des Isolationsfehlersuchsystems von der Gesamtkonfiguration des IT -Systems bestimmt und kann negativ beeinträchtigt werden.

Bei bekannten Ausführungen von Isolationsfehlersuchsystemen ist das Prüfsignal zusätzlich abhängig von der Nennspannung des zu überwachenden IT-Systems. Auch dies ist ein weiterer Parameter, welcher die Empfindlichkeit des Isolationsfehlersuchsystems beeinflusst und die Komplexität der Isolationsfehlersuche steigert. Eine weitere Besonderheit entsteht bei Isolationsfehlersuchsystemen, die impulsförmige Prüfsignale, vornehmlich in Form einer Rechtecksignalfolge, in das IT-System einspeisen. Hier müssen die Einschwingvorgänge durch verteilt vorhandene Netzableitkapazitäten beachtet werden. Das Verhältnis der Netzableitkapazitäten vor und nach der Differenzstrommesseinrichtung im Subnetz bestimmt zusätzlich die erreichbare Empfindlichkeit der Isolationsfehlersucheinrichtung.

Diese Überlegungen zeigen, dass der effiziente Einsatz eines Isolationsfehlersuchsystems die Kenntnis und Berücksichtigung der elektrischen Größen des gesamten IT-Systems voraussetzt. Auch die Kenntnis der Querverbindungsimpedanzen, also der komplexwertigen Ableitstrom-führenden Impedanzen zwischen den Subsystemen wäre von Vorteil.

Erschwert wird die Durchführung der Isolationsfehlersuche insbesondere in ausgedehnten, weitverzweigten IT-Systemen weiterhin dadurch, dass nicht immer eine Netzkonfiguration vorhanden ist, die eine hinreichend empfindliche Bestimmung von Isolationsfehlern in dem fehlerbehafteten Subnetz zulässt.

Neben diesen Schwierigkeiten bei der Isolationsfehlersuche tritt auch bei der ständigen Isolationsüberwachung das Problem auf, dass es nach dem derzeitigen Stand der Technik nicht möglich ist, das IT-System von mehr als einem Isolationsüberwachungsgerät gleichzeitig aktiv überwachen zu lassen. Die aktiven Messsysteme von zwei oder mehr aktiven Isolationsüberwachungsgeräten in einem IT-System könnten sich gegenseitig so beeinflussen, dass die Überwachungsaufgabe nicht zuverlässig gewährleistet ist. Da immer der Leitwert der Parallelschaltung aller komplexwertigen Isolationswiderstände im Gesamtsystem ausgewertet wird, das Isolationsüberwachungsgerät also alle vorhandenen Netzableitkapazitäten in dem IT-System sieht, muss das Messsystem des Isolationsüberwachungsgerätes so ausgelegt sein, dass es den durch die Subsysteme erzeugten Störeinflüssen begegnen kann. In einigen Applikationen wird die selektive Überwachung von IT-Subsystemen in der Weise gefordert, dass ein Isolationsfehler in einem IT-Subsystem zur schnellen Abschaltung des betroffenen Subsystems und ohne Beeinflussung anderer IT-Subsysteme führen soll. Mit Isolationsüberwachungssystemen nach dem Stand der Technik kann diese Forderung bislang nicht erfüllt werden.

Dort, wo eine selektive Isolationsüberwachung gefordert wird, bzw. bei der benötigten Reaktion auf einen kritischen zweiten Fehler im IT-System, wird versucht, mit dem Einsatz von richtungsselektiver Differenzstrommesstechnik bzw. auch in einfacher Weise mit Überstromauslösern brauchbare Lösungen zu realisieren. Diese Lösungen sind jedoch in IT-Systemen nur unter bestimmten Konfigurationen zuverlässig einsetzbar. Bei der richtungsselektiven Differenzstrommesstechnik ist z.B. das Verhältnis der Netzableitkapazitäten vor dem Summenstromwandler und der Netzableitkapazitäten nach dem Summenstromwandler entscheidend dafür, ob die richtungsselektive Messung zuverlässig funktioniert.

Der vorliegenden Erfindung liegt somit die Aufgabe zu Grunde, eine Isolationsfehlersucheinrichtung zu entwerfen, die eine schnelle und zuverlässige Detektion von Isolationsfehlern in einem verzweigten, mehrere Subsysteme umfassenden IT-System ermöglicht. Weiterhin besteht die Aufgabe darin, für ein verzweigtes IT-System eine Isolationsüberwachungseinrichtung zu entwerfen, die eine schnelle und zuverlässige Überwachung des gesamten Isolationszustandes des IT-Systems erlaubt. Weiterhin ist ein Verfahren erstrebenswert, das über die Bestimmung des Isolationswiderstandes hinaus weitere Informationen über den Isolationszustand des IT-Systems liefert.

Diese Aufgabe wird bezogen auf die Isolationsfehlersuche in Verbindung mit dem Oberbegriff des Anspruchs 1 dadurch gelöst, dass in dem Subsystem ein Prüfsignalgenerator zur seriellen Einspeisung eines Prüfsignals angeordnet ist und dass das Subsystem eine schaltungstechnische Blockierungseinrichtung aufweist, die die Wirksamkeit des in dieses Subsystem eingespeisten Prüfsignals auf dieses Subsystem begrenzt.

Indem für jedes Subsystem separat ein Prüfsignalgenerator sowie eine Blockierungseinrichtung vorgesehen sind, kann in Verbindung mit der ebenfalls in jedem Subsystem vorhandenen Differenzstrommesseinrichtung eine auf das jeweilige Subsystem optimierte Isolationsfehlersuche durchgeführt werden. Unbeeinflusst von dem elektrischen Zustand des übrigen IT-Systems ist somit eine schnelle und zuverlässige Detektion von Isolationsfehlern möglich. Die messtechnische Auslegung des Isolationsfehlersuchsystems ist damit so gestaltet, dass die elektrischen Kenngrößen jedes Subsystems berücksichtigt werden können.

Im Gegensatz zu aus dem Stand der Technik bekannten Isolationsfehlersuchsystemen können bei dem erfindungsgemäßen Isolationsfehlersuchsystem die Mess- und Überwachungszyklen auf das jeweilige Subsystem angepasst und unabhängig von den anderen Subsystemen frei eingestellt werden. In kritischen Subsystemen wird eventuell in kürzeren Abständen ein Prüfsignal eingespeist und eine sehr schnelle Messung realisiert. In robusten, wenig störanfälligen Subsystemen könnte z.B. mit größeren Prüfsignalamplituden gearbeitet werden, in sensiblen Subsystemen können vorteilhaft geringere Prüfsignalamplituden gewählt werden.

Die Verwendung einer Blockierungseinrichtung und die damit verbundene gegenseitige Abkapselung der Messeinrichtungen in den Subsystemen führt vorteilhaft dazu, dass die einstellbaren Messparameter bzw. Prüfparameter wie z.B. Prüfsignalamplitude und Prüfsignalfrequenz optimal an die Gegebenheiten (Netzableitkapazität, Störungen) des zu überwachenden Subsystems angepasst werden können ohne die Messaufgabe in anderen Subsystemen zu beeinflussen.

Die Blockierungseinrichtung verhindert somit eine Rückwirkung des für das jeweilige Subsystem optimierten Prüfsignals auf das übrige IT-System.

Durch das Isolationsfehlersuchsystem mit zweigselektiver, serieller Einprägung eines Prüfsignals in jedes Subnetz separat kann bei gleichzeitiger weitgehender Begrenzung der Wirksamkeit des eingeprägten Prüfsignals auf das betreffende Subnetz durch die Blockierungseinrichtung eine zuverlässige und schnelle Isolationsfehlersuche in dem Gesamtsystem erfolgen.

In weiterer vorteilhafter Ausgestaltung ist der Prüfsignalgenerator zur Erzeugung von Prüfsignalen ausgelegt, die eine unterschiedliche Signalform und einstellbare Signalparameter aufweisen.

Jeder Prüfsignalgenerator erlaubt somit eine individuelle, an die elektrischen Eigenschaften des betreffenden Subsystems angepasste Erzeugung und Einspeisung eines speziell für das jeweilige Subsystem optimal geeigneten Prüfsignals. So ist es möglich, die Prüfsignalform, weitere Prüfsignalparameter und die damit verbundenen Auswerteverfahren einstellbar zu gestalten und frei zu wählen, um eine möglichst robuste Detektion der Isolationsfehler in dem gesamten IT-System realisieren zu können. Weiterhin bietet diese Ausgestaltung des Prüfsignalgenerators die Möglichkeit der sequentiellen Umschaltung auf unterschiedliche Prüfsignale, um weiteren Mess- und Überwachungsaufgaben gerecht zu werden. Beispielhaft sei hier die Mehrfachmessung mit unterschiedlichen Prüfsignalen zur selektiven Bestimmung von Ableitstrom-führenden Querverbindungen zwischen zwei Subsystemen genannt.

In weiteren Ausgestaltungen ist der Prüfsignalgenerator als Sinus-Signalgenerator oder als Impuls-Signalgenerator ausgeführt.

So kann in Abhängigkeit der elektrischen Kenngrößen wie beispielsweise den Netzableitkapazitäten des IT-Systems und im Hinblick auf die zu erwartenden Störeinflüsse die Einspeisung eines sinusförmigen Prüfsignals oder eines impulsförmigen Prüfsignals mit jeweils angepassten Prüfsignalparametern geeigneter erscheinen, um eine möglichst fehlerfreie Messung durchführen zu können.

Vorteilhafterweise weist die Blockierungseinrichtung eine einstellbare Selektivität auf, die die Stärke der Begrenzung der Wirksamkeit des Prüfsignals bestimmt. Durch diese einstellbare Prüfsignalselektivität kann bestimmt werden, wie stark das Prüfsignal der Blockierungseinrichtung in einem betrachteten Subsystem von dem übrigen Stromversorgungsnetz abgekoppelt werden soll. Dies kann beispielsweise durch eine Veränderung und Voreinstellung der bei der Prüfsignalfrequenz wirksamen Impedanz der Blockierungseinrichtung erfolgen.

Bevorzugt ist die Blockierungseinrichtung als Serienresonanzkreis ausgeführt. Ausgehend von den elektrischen Eigenschaften des IT-Systems sowie von den zu erwartenden Störungen und damit in Abhängigkeit der Prüfsignalform besteht die Blockierungseinrichtung im Fall eines sinusförmigen Prüfsignals aus einem passiven Serienresonanzkreis, dessen Resonanzfrequenz der Frequenz des eingespeisten Prüfsignals entspricht und der durch seine im Resonanzfall durch den ohmschen Widerstand bestimmte minimale Impedanz bewirkt, dass nur ein geringer Teil des Prüfstroms in das übrige "davorliegende" IT-System abfließt.

Im Fall eines impulsförmigen Prüfsignals, beispielsweise in Form einer Rechtecksignalfolge, ist die Blockierungseinrichtung vorteilhafterweise als Kammfilter ausgeführt. Das aktive Kammfilter bewirkt für die jeweiligen Prüfsignalanteile des betreffenden Subsystems eine niederohmige Verbindung mit Erdpotential und verhindert, dass das übrige IT-System durch das Prüfsignal beeinflusst wird.

Weiterhin ist die Einspeisung des Prüfsignals als serielle Einspeisung eines Gleichtaktsignals ausgeführt. Dabei wird das Prüfsignal allen aktiven Leitern des Subnetzes mit gleicher Phase überlagert.

Bezogen auf die Isolationsüberwachung in einem verzweigten, aus mehreren Subsystemen bestehenden IT-System wird die Aufgabe in Verbindung mit den Merkmalen des Isolationsfehlersuchsystems nach den Ansprüchen 1 bis 8 dadurch gelöst, dass das Subsystem eine selektive Entkopplungseinrichtung aufweist, die bei Auftreten eines Isolationsfehlers in einem Subsystem dieses Subsystem von dem übrigen IT-System messtechnisch entkoppelt und damit eine Beeinflussung der Messungen in dem übrigen IT-System verhindert.

Basierend auf den vorgenannten Merkmalen kann das Isolationsfehlersuchsystem zu einem selektiven Isolationsüberwachungssystem erweitert werden. Der in dem jeweiligen Prüfstromgenerator erzeugte und seriell in das Subsystem eingespeiste Prüfstrom kann dabei als Messstrom für die Isolationsüberwachung konfiguriert werden. Dieser Messstrom wird im Gegensatz zur Verarbeitung in bekannten Isolationsüberwachungsgeräten nicht an dem Messwiderstand eines Isolationsüberwachungsgerätes gemessen, sondern wird wie der obengenannte Prüfstrom ebenfalls über die Differenzstrommesseinrichtung des jeweiligen Subsystems erfasst.

Damit ein in einem Subsystem auftretender Isolationsfehler nicht die Messungen in dem übrigen IT-System beeinflusst, weist das erfindungsgemäße Isolationsüberwachungssystem zusätzlich zu den Merkmalen des Isolationsfehlersuchsystems die Entkopplungseinrichtung auf.

Diese Maßnahme ist notwendig, um insbesondere bei einem Isolationsfehler mit einem Fehlerwiderstand nahe bei null Ohm (Erdschluss) in einem Subsystem keinen störendenden Einfluss auf die Mess- und Überwachungsaufgaben in dem übrigen Netzwerk zu erzeugen. Bezüglich der Mess- und Überwachungsaufgabe bleibt die Auswirkung des Isolationsfehlers somit auf das betroffene Subsystem beschränkt. Hinsichtlich der eigentlichen Versorgungsaufgabe, also bei Betriebs-Netzfrequenz des zu überwachenden IT-Systems muss sich die selektive Entkopplungseinrichtung möglichst wie ein niederohmiger Leitungswiderstand verhalten, um nicht den bestimmungsgemäßen Betrieb des IT-Systems, also z.B. die Energieversorgung des betroffenen Zweiges, unzulässig zu beeinflussen. Mit Hilfe der selektiven Entkopplungseinrichtung ist es möglich, bei einem niederohmigen Isolationsfehler in einem Subsystem gleichzeitig auch vorhandene weiterhin hochohmige, fehlerfreie Subsysteme zu überwachen.

Eine vollständige Begrenzung des Einflusses eines Isolationsfehlers in einem Subsystem auf das gesamte IT-System lässt sich allerdings nur dann erreichen, wenn das betroffene Subsystem im Fehlerfall gezielt abgeschaltet wird.

Durch die erfindungsgemäße Ausgestaltung mit der selektiven Entkopplungseinrichtung lässt sich das beanspruchte Isolationsüberwachungssystem sowohl in ungeerdeten als auch in geerdeten Systemen einsetzen. Zudem ist eine parallele Isolationsüberwachung in verschiedenen Subsystemen möglich.

Das erfindungsgemäße Isolationsüberwachungssystem kann optimal auf die Gegebenheiten des einzelnen Subsystems angepasst werden. Liegen z.B. in einem Subsystem nur geringe Netzableitkapazitäten vor, so kann die Isolationsüberwachung für dieses Subnetz sehr schnell Ergebnisse liefern, auch wenn in anderen Subnetzen sehr große Netzableitkapazitäten vorliegen. Damit wird auch das Problem einer selektiv wirkenden Isolationsüberwachung gelöst. Ein zweiter Fehler kann somit sicher erkannt werden.

In weiterer vorteilhafter Ausgestaltung weist die selektive Entkopplungseinrichtung eine einstellbare Selektivität auf, die den Grad der Entkopplung bestimmt.

Bevorzugt wird in der selektiven Entkopplungseinrichtung für die Prüfsignale eine hinreichend hochohmige Impedanz erzeugt. Um bei Auftreten eines Isolationsfehlers in einem Subsystem eine Beeinflussung der Messungen in dem übrigen IT-System weitgehend zu verhindern, stellt somit der fehlerhafte Zweig für die Prüfsignale des übrigen Netzwerks eine hochohmige Impedanz dar. Diese Impedanz ist beispielsweise hinsichtlich ihrer Frequenzabhängigkeit an die jeweilige Mess- und Überwachungsaufgabe anpassbar. Bei der Betriebs-Netzfrequenz muss die Entkopplungseinrichtung, wie oben bemerkt, hinreichend niederohmig sein, um den bestimmungsgemäßen Betrieb des gesamten IT-Systems nicht unzulässig zu beeinflussen.

In weiterer Ausgestaltung ist bei Einspeisung eines sinusförmigen Prüfsignals die Entkopplungseinrichtung bevorzugt als Parallelschwingkreis ausgeführt. Diese Ausgestaltung ermöglicht, dass eine hochohmige Impedanz bei genau der Resonanzfrequenz des Parallelschwingkreises erzeugt wird, die der Frequenz des eingespeisten sinusförmigen Prüfsignals entspricht.

Bezogen auf ein Verfahren zur Bestimmung einer Querverbindungsimpedanz zwischen zwei Subsystemen in einem verzweigten IT-System mit einem erfindungsgemäßen Isolationsüberwachungssystem wird die Aufgabe dadurch gelöst, dass die zwei Subsysteme in einer sequentiellen Mehrfachmessung zuerst jeweils mit dem gleichen Prüfsignal bei gleicher Einstellung der Selektivitäten der Blockierungseinrichtung und der Entkopplungseinrichtung beaufschlagt werden, darauffolgend mit verschiedenen Prüfsignalen bei verschiedenen Einstellungen der Selektivitäten beaufschlagt werden und aus der Differenz der gemessenen Isolationswiderstandswerte die Querverbindungsimpedanz bestimmt wird.

Zwei Subsysteme können in einem ersten Schritt zunächst jeweils mit dem gleichen Prüfsignal und den gleichen Einstellungen der Prüfsignalselektivitäten der Blockierungseinrichtung und der Entkopplungseinrichtung betrieben werden, in einem zweiten Schritt mit verschiedenen Prüfsignalen und verschiedenen Prüfsignalselektivitäten und in einem dritten Schritt kann aus einem Vergleich der in den Schritten eins und zwei gemessenen Isolationswiderstandswerte die Querverbindungsimpedanz bestimmt werden - wobei die Reihenfolge der ersten beiden Schritte vertauschbar ist.

Im Falle des gleichen Prüfsignals und der gleichen Prüfsignalselektivitäten, also bei gleichen Prüfparametern für beide Subsysteme werden auch ohmsche und kapazitive Querverbindungen zwischen den beiden Subsystemen mitgemessen. Verwenden die beiden Subsysteme des IT-Systems die gleichen Prüfsignale, so fließen Prüfstromanteile nicht nur über eventuell vorhandene Ableitimpedanzen gegen Erde sondern auch über eventuell vorhandene Querverbindungen zwischen den beiden Subsystemen.

Im Falle der unterschiedlichen Prüfparameter werden auf Grund der guten Entkopplung nur die ohmschen und kapazitiven Verbindungen gegen Erde bestimmt. Die Prüfsignalanteile, die in anderen Subsystemen Verwendung finden, werden für das betrachtete Subsystem abgeschirmt, so dass Querverbindungen zu anderen Subsystemen geringen Einfluss auf die Messung des Isolationswiderstands im betrachteten Subsystem haben.

Die Differenz aus beiden Messungen lässt auf den Widerstandswert der Querverbindungen schließen.

Durch diese sequentielle Mehrfachmessung mit gleichen und unterschiedlichen Prüfsignalen und entsprechender Einstellung der (Prüfsignal-)Selektivitäten der Blockierungseinrichtungen und der Entkopplungseinrichtung der beiden Subsysteme lassen sich der komplexwertige Isolationswiderstand (Ableitimpedanz) der einzelnen Subsysteme gegen Erde und die Querverbindungs-Impedanz zwischen den betrachteten Subsystemen ermitteln.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein Isolationsfehlersuchsystem nach dem Stand der Technik,
- **Fig. 2:**: ein erfindungsgemäßes Isolationsfehlersuchsystem mit zweigselektiver Einspeisung,
- **Fig. 3:**: ein erfindungsgemäßes selektives Isolationsüberwachungssystem und
- **Fig. 4:**: ein Ausführungsbeispiel eines Subnetzes für impulsförmige Prüfsignale.

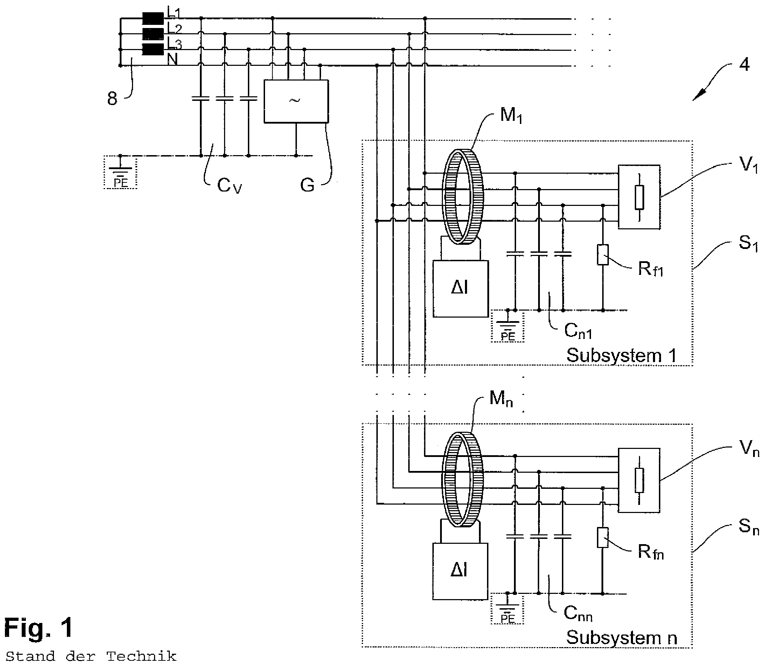

Die **Fig. 1** zeigt den Aufbau eines typischen, dem Stand der Technik entsprechenden Isolationsfehlersuchsystems für ein verzweigtes IT-System 4 mit n Subsystemen (Subnetzen) S₁,.., Sₙ. Das IT-System 4 ist beispielhaft als 3-phasiges Stromversorgungsnetz mit den Außenleitern L₁, L₂, L₃, dem Neutralleiter N und dem Schutzleiter PE ausgebildet. Die aktiven Leiter L₁, L₂, L₃ und N verbinden die Stromquelle 8 über ein verzweigtes Leitungssystem mit den jeweiligen Verbrauchern V₁,.., Vₙ in den einzelnen Subsystemen S₁,.., Sₙ. An zentraler Position ist in dem Hauptsystem ein Prüfsignalgenerator G zur Einspeisung eines Prüfsignals angeordnet. Sofern in einem Subsystem S₁,.., Sₙ ein Isolationsfehler mit dem Fehlerwiderstand R_{f1},.., R_{fn} auftritt, wird das Prüfsignal in dem fehlerbehafteten Subsystem S₁,.., Sₙ von einer Differenzstrommesseinrichtung M₁,.., Mₙ erfasst und kann anschließend in einer zentralen Auswerteeinheit bewertet werden.

Die dargestellte Netzkonfiguration ist weiterhin gekennzeichnet durch die Netzableitkapazitäten Cᵥ und Cₙ₁,.., Cₙₙ, wobei die verteilt auftretenden Netzableitkapazitäten Cᵥ, Cₙ₁,.., Cₙₙ hier als konzentrierte Elemente beschrieben sind, die vor (Cᵥ) und nach (Cₙ₁,.., Cₙₙ) den Differenzstromeinrichtungen M₁,.., Mₙ angeordnet sind.

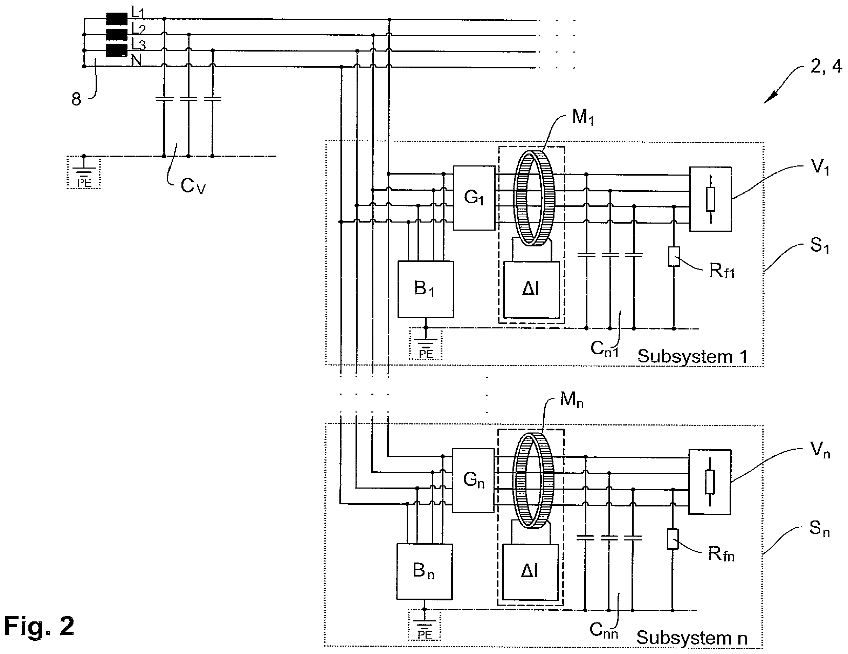

In **Fig. 2** ist ein erfindungsgemäßes Isolationsfehlersuchsystem 2 mit zweigselektiver Einspeisung dargestellt. Im Gegensatz zu der zentralen Einspeisung des Prüfsignals bei dem Isolationsfehlersuchsystem nach dem Stand der Technik aus Fig. 1 weist das erfindungsgemäße Isolationsfehlersuchsystem 2 für jedes Subsystem S₁,.., Sₙ einen Prüfsignalgenerator G₁,.., Gₙ zur seriellen Einspeisung eines individuell auf die elektrischen Kenngrößen des IT-Systems 4, insbesondere des jeweiligen Subsystems S₁,.., Sₙ, abgestimmten Prüfsignals auf. In dem dargestellten 3-phasigen Stromversorgungssystem 4 speist der Prüfsignalgenerator G₁,.., Gₙ ein Gleichtaktprüfsignal seriell in jede Subnetzphase ein. Dieses Gleichtaktprüfsignal kann beispielsweise ein sinusförmiges 1V/1kHz-Prüfsignal oder ein impulsförmiges Signal sein.

Daneben umfasst jedes Subsystem S₁,.., Sₙ eine Blockierungseinrichtung B₁,.., Bₙ, um eine Rückwirkung des in das jeweilige Subsystem S₁,.., Sₙ eingespeisten Prüfsignals auf das übrige IT-System zu verhindern.

Im Fall der Einspeisung eines sinusförmigen 1V/1kHz-Prüfsignals ist die betreffende Blockierungseinrichtung B₁,.., Bₙ vorzugsweise als Reihenschwingkreis gegen Erde mit einer Resonanzfrequenz von 1 kHz realisiert. Simulationsergebnisse zeigen, dass bei einer Auslegung des Reihenschwingkreises mit einem ohmschen Widerstand von 100 mOhm und mit Modellierung der vorgelagerten Netzableitkapazität von 20 µF nur näherungsweise 1/80 des 1kHz-Prüfstroms aus dem Subsystem S₁,.., Sₙ in das davor liegende Netz fließt.

Weiterhin ist in jedem Subsystem S₁,.., Sₙ eine zur Erfassung des Prüfstroms geeignete Differenzstrommesseinrichtung M₁,.., Mₙ angeordnet.

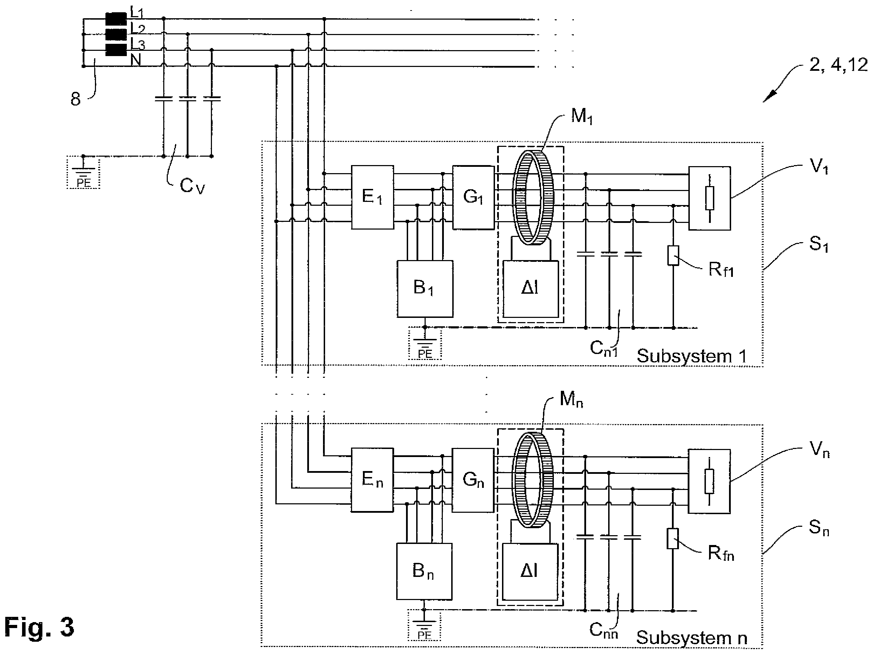

Die **Fig.3** zeigt das in Fig. 2 dargestellte Isolationsfehlersuchsystem 2, das um eine in jedem Subsystem S₁,.., Sₙ angeordnete Entkopplungseinrichtung E₁,.., Eₙ erweitert worden ist und somit zu der Realisierung eines erfindungsgemäßen, selektiven Isolationsüberwachungssystems 12 führt.

Erfolgt beispielsweise in einem Subsystem S₁,.., Sₙ ein satter Erdschluss, d.h. eine Subnetzphase wird mit vernachlässigbarem Widerstand mit Erde verbunden, so wird die Abkapselung der einzelnen Subnetze S₁,.., Sₙ mit dem Reihenschwingkreis der Blockierungseinrichtung B₁,.., Bₙ gegen Erde als alleinige Maßnahme nicht mehr hinreichend wirksam sein. In Kombination mit dem Parallelschwingkreis aus der Entkopplungseinrichtung E₁,.., Eₙ jedoch ist die Abkapselung des fehlerbehafteten Subnetzes S₁,.., Sₙ auch in diesem kritischen Fall gewährleistet.

Für Isolationsfehlersuchsysteme bringt diese zusätzliche Entkopplung eine zusätzliche Messsicherheit, ist aber nicht prinzipiell notwendig.

Um die Beeinflussung der netzfrequenten Energieübertragung im Subnetz S₁,.., Sₙ durch den Einsatz einer Entkopplungseinrichtung E₁,.., Eₙ in Form eines Parallelschwingkreises zu minimieren, ist es vorteilhaft, statt Einzelinduktivitäten gekoppelte Induktivitäten zu verwenden. Diese "stromkompensierten Drosseln" bieten für den netzfrequenten (Gegentakt-)Laststrom einen kaum wirksamen Induktivitätsanteil, für den prüfsignalfrequenten (Gleichtakt-)Messstrom ist hingegen die volle Induktivität wirksam.

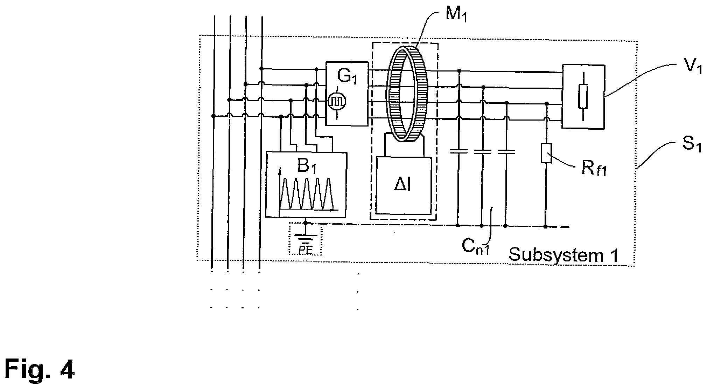

Die **Fig. 4** zeigt ein Ausführungsbeispiel eines Subnetzes S₁,.., Sₙ für impulsförmige Prüfsignale. Statt eines passiven Reihenschwingkreises ist die Blockierungseinrichtung B₁ als aktives Kammfilter ausgebildet, das nur für die Prüfsignalanteile des betreffenden Subsystems S₁,.., Sₙ eine niederohmige Verbindung mit Erdpotential bewirkt.

## Patentansprüche

1. Isolationsfehlersuchsystem (2) für ein verzweigtes IT-System (4) mit einem Subsystem (S₁,.., Sₙ), mit einer in dem Subsystem (S₁,.., Sₙ) angeordneten Differenzstrommesseinrichtung (M₁,.., Mₙ) zur Erfassung eines Differenzstrom-Messsignals,
**dadurch gekennzeichnet,**
**dass** in dem Subsystem (S₁,.., Sₙ) des verzweigten IT-Systems ein Prüfsignalgenerator (G₁,.., Gₙ) zur seriellen Einspeisung eines Prüfsignals angeordnet ist und dass das Subsystem (S₁,.., Sₙ) eine schaltungstechnische Blockierungseinrichtung (B₁,.., Bₙ) aufweist, die die Wirksamkeit des in dieses Subsystem (S₁,.., Sₙ) eingespeisten Prüfsignals auf dieses Subsystem (S₁,.., Sₙ) begrenzt.

2. Isolationsfehlersuchsystem (2) nach Anspruch 1,
**dadurch gekennzeichnet,**
**dass** der Prüfsignalgenerator (G₁,.., Gₙ) zur Erzeugung von Prüfsignalen ausgelegt ist, die eine unterschiedliche Signalform und einstellbare Signalparameter aufweisen.

3. Isolationsfehlersuchsystem (2) nach Anspruch 1 oder 2,
**dadurch gekennzeichnet,**
**dass** der Prüfsignalgenerator (G₁,.., Gₙ) zur Erzeugung eines sinusförmigen Prüfsignals ausgeführt ist.

4. Isolationsfehlersuchsystem (2) nach einem der Ansprüche 1 bis 3,
**dadurch gekennzeichnet,**
**dass** der Prüfsignalgenerator (G₁,.., Gₙ) zur Erzeugung eines impulsförmigen Prüfsignals ausgeführt ist.

5. Isolationsfehlersuchsystem (2) nach einem der Ansprüche 1 bis 4,
**dadurch gekennzeichnet,**
**dass** die Blockierungseinrichtung (B₁,.., Bₙ) eine einstellbare Selektivität aufweist, die die Stärke der Begrenzung der Wirksamkeit des Prüfsignals bestimmt.

6. Isolationsfehlersuchsystem (2) nach einem der Ansprüche 1 bis 5,
**dadurch gekennzeichnet,**
**dass** die Blockierungseinrichtung (B₁,.., Bₙ) als Serienresonanzkreis ausgeführt ist.

7. Isolationsfehlersuchsystem (2) nach einem der Ansprüche 1 bis 5,
**dadurch gekennzeichnet,**
**dass** die Blockierungseinrichtung (B₁,.., Bₙ) als Kammfilter ausgeführt ist.

8. Isolationsfehlersuchsystem (2) nach einem der Ansprüche 1 bis 7,
**dadurch gekennzeichnet,**
**dass** die Einspeisung des Prüfsignals als serielle Einspeisung eines Gleichtaktsignals ausgeführt ist.

9. Isolationsüberwachungssystem (12) zur Überwachung eines Isolationswiderstandes in einem verzweigten IT-System (4) mit einem Subsystem (S₁,.., Sₙ), mit den Merkmalen eines Isolationsfehlersuchsystems (2) nach einem der Ansprüche 1 bis 8,
**dadurch gekennzeichnet,**
**dass** das Subsystem (S₁,.., Sₙ) eine selektive Entkopplungseinrichtung (E₁,.., Eₙ) aufweist, die bei Auftreten eines Isolationsfehlers (R_{f1},.., R_{fn}) in einem Subsystem (S₁,.., Sₙ) dieses Subsystem (S₁,.., Sₙ) von dem übrigen IT-System messtechnisch entkoppelt und damit eine Beeinflussung der Messungen in dem übrigen IT-System verhindert.

10. Isolationsüberwachungssystem (12) nach Anspruch 9,
**dadurch gekennzeichnet,**
**dass** die selektive Entkopplungseinrichtung (E₁,.., Eₙ) eine einstellbare Selektivität aufweist, die den Grad der Entkopplung bestimmt.

11. Isolationsüberwachungssystem (12) nach Anspruch 9 oder 10,
**dadurch gekennzeichnet,**
**dass** die selektive Entkopplungseinrichtung (E₁,.., Eₙ) für die Prüfsignale eine hinreichend hochohmige Impedanz darstellt.

12. Isolationsüberwachungssystem (12) nach einem der Ansprüche 9 bis 11,
**dadurch gekennzeichnet,**
**dass** bei Einspeisung eines sinusförmigen Prüfsignals die Entkopplungseinrichtung (E₁,.., Eₙ) als Parallelschwingkreis ausgeführt ist.

13. Verfahren zur Bestimmung einer Querverbindungsimpedanz zwischen zwei Subsystemen (S₁,.., Sₙ) in einem verzweigten IT-System (4) mit einem erfindungsgemäßen Isolationsüberwachungssystem (12) nach einem der Ansprüche 9 bis 12,
**dadurch gekennzeichnet,**
**dass** die zwei Subsysteme (S₁,.., Sₙ) in einer sequentiellen Mehrfachmessung zuerst jeweils mit dem gleichen Prüfsignal bei gleicher Einstellung der Selektivitäten der Blockierungseinrichtung und der Entkopplungseinrichtung beaufschlagt werden, darauffolgend mit verschiedenen Prüfsignalen bei verschiedenen Einstellungen der Selektivitäten beaufschlagt werden und aus der Differenz der gemessenen Isolationswiderstandswerte die Querverbindungsimpedanz bestimmt wird.

## Claims

1. An insulation fault locating system (2) for a branched IT system (4) with a subsystem (S₁,.., Sₙ), comprising a differential current measuring device (M₁,.., Mₙ) arranged in the subsystem (S₁,.., Sₙ) for registering a differential current measuring signal,
**characterized in that**
a test signal generator (G₁,.., Gₙ) for serial feeding of a test signal is arranged in the subsystem (S₁,.., Sₙ)of the branched IT system and that the subsystem (S₁,.., Sₙ) has a circuit wired blocking device (B₁,.., Bₙ) which limits the effectiveness of the test signal fed into said subsystem (S₁,.., Sₙ) to said subsystem (S₁,.., Sₙ).

2. The insulation fault locating system (2) according to claim 1,
**characterized in that**
the test signal generator (G₁,.., Gₙ) is configured to generate test signals that have a different signal shape and adjustable signal parameters.

3. The insulation fault locating system (2) according to claim 1 or 2,
**characterized in that**
the test signal generator (G₁,.., Gₙ) is configured to generate a sinusoidal test signal.

4. The insulation fault locating system (2) according to any one of claims 1 to 3,
**characterized in that**
the test signal generator (G₁,.., Gₙ) is configured to generate a pulse-shaped test signal.

5. The insulation fault locating system (2) according to any one of claims 1 to 4,
**characterized in that**
the blocking device (B₁,.., Bₙ) has an adjustable selectivity which determines the degree of limitation of the effectiveness of the test signal.

6. The insulation fault locating system (2) according to any one of claims 1 to 5,
**characterized in that**
the blocking device (B₁,.., Bₙ) is configured as a series resonant circuit.

7. The insulation fault locating system (2) according to any one of claims 1 to 5,
**characterized in that**
the blocking device (B₁,.., Bₙ) is configured as a comb filter.

8. The insulation fault locating system (2) according to any one of claims 1 to 7,
**characterized in that**
the feeding of the test signal is implemented as a serial feeding of a common-mode signal.

9. An insulation monitoring system (12) for monitoring an insulation resistance in a branched IT system (4) with a subsystem (S₁,.., Sₙ), having the features of an insulation fault locating system (2) according to any one of claims 1 to 8,
**characterized in that**
the subsystem (S₁,.., Sₙ) has a selective decoupling device (E₁,.., Eₙ) which decouples a subsystem (S₁,.., Sₙ) from the remaining IT system with regard to measurement when an insulation fault (R_{f1},.., R_{fn}) occurs in said subsystem (S₁,.., Sₙ) and thereby prevents the measurements in the remaining IT system from being influenced.

10. The insulation monitoring system (12) according to claim 9,
**characterized in that**
the selective decoupling device (E₁,.., Eₙ) has an adjustable selectivity which determines the degree of decoupling.

11. The insulation monitoring system (12) according to claim 9 or 10,
**characterized in that**
the selective decoupling device (E₁,.., Eₙ) presents a sufficiently high impedance for the test signals.

12. The insulation monitoring system (12) according to any one of claims 9 to 11,
**characterized in that**
the decoupling device (E₁,.., Eₙ) is configured as a parallel resonant circuit if a sinusoidal test signal is fed in.

13. A method for determining a cross-connection impedance between two subsystems (S₁,.., Sₙ) in a branched IT system (4) with an insulation monitoring system (12) according to the invention according to any one of claims 9 to 12,
**characterized in that**
in a sequential multiple measurement, at first, each of the two subsystems (S₁,.., Sₙ) is supplied with the same test signal, the same selectivity of the blocking device and of the decoupling device being set, then they are supplied with different test signals, a different selectivity being set, and the cross-connection impedance is determined from the difference of the measured insulation resistance values.

## Revendications

1. Système de localisation de défauts d'isolement (2) pour un système informatique (4) ramifié avec un sous-système (S₁,.., Sₙ), comprenant un dispositif de mesure de courant différentiel (M₁,.., Mₙ) disposé dans le sous-système (S₁,.., Sₙ) pour enregistrer un signal de mesure de courant différentiel,
**caractérisé en ce**
**qu'**un générateur de signaux d'essai (G₁,.., Gₙ) pour l'alimentation en série d'un signal d'essai est disposé dans le sous-système (S₁,.., Sₙ) du système informatique ramifié et **en ce que** le sous-système (S₁,.., Sₙ) a un dispositif de blocage (B₁,.., Bₙ) formant un circuit qui limite l'efficacité du signal d'essai alimenté dans ledit sous-système (S₁,.., Sₙ) à ledit sous-système (S₁,.., Sₙ).

2. Système de localisation de défauts d'isolement (2) selon la revendication 1,
**caractérisé en ce que**
le générateur de signaux d'essai (G₁,.., Gₙ) est configuré pour générer des signaux d'essai qui ont une forme de signal différente et des paramètres de signal réglables.

3. Système de localisation de défauts d'isolement (2) selon la revendication 1 ou 2,
**caractérisé en ce que**
le générateur de signaux d'essai (G₁,.., Gₙ) est réalisé pour générer un signal d'essai sinusoïdal.

4. Système de localisation de défauts d'isolement (2) selon l'une quelconque des revendications 1 à 3,
**caractérisé en ce que**
le générateur de signaux d'essai (G₁,.., Gₙ) est réalisé pour générer un signal d'essai en forme d'impulsion.

5. Système de localisation de défauts d'isolement (2) selon l'une quelconque des revendications 1 à 4,
**caractérisé en ce que**
le dispositif de blocage (B₁,.., Bₙ) a une sélectivité réglable qui détermine le degré de la limitation de l'efficacité du signal d'essai.

6. Système de localisation de défauts d'isolement (2) selon l'une quelconque des revendications 1 à 5,
**caractérisé en ce que**
le dispositif de blocage (B₁,.., Bₙ) est réalisé comme circuit résonnant série.

7. Système de localisation de défauts d'isolement (2) selon l'une quelconque des revendications 1 à 5,
**caractérisé en ce que**
le dispositif de blocage (B₁,.., Bₙ) est réalisé comme filtre en peigne.

8. Système de localisation de défauts d'isolement (2) selon l'une quelconque des revendications 1 à 7,
**caractérisé en ce que**
l'alimentation du signal d'essai est réalisée comme alimentation en série d'un signal de mode commun.

9. Système de surveillance d'isolation (12) pour la surveillance d'une résistance d'isolement dans un système informatique (4) ramifié avec un sous-système (S₁,.., Sₙ), ayant les caractéristiques d'un système de localisation de défauts d'isolement (2) selon l'une quelconque des revendications 1 à 8,
**caractérisé en ce que**
le sous-système (S₁,.., Sₙ) a un dispositif de découplage (E₁,.., Eₙ) sélectif qui découple un sous-système (S₁,.., Sₙ) du reste du système informatique en ce qui concerne la mesure en cas de défaut d'isolement (R_{f1},.., R_{fn}) dans ledit sous-système (S₁,.., Sₙ) et empêche ainsi que les mesures soient influées dans le reste du système informatique.

10. Système de surveillance d'isolation (12) selon la revendication 9,
**caractérisé en ce que**
le dispositif de découplage (E₁,.., Eₙ) sélectif a une sélectivité réglable qui détermine le degré de découplage.

11. Système de surveillance d'isolation (12) selon la revendication 9 ou 10,
**caractérisé en ce que**
le dispositif de découplage (E₁,.., Eₙ) sélectif constitue une impédance de valeur ohmique suffisamment élevée pour les signaux d'essai.

12. Système de surveillance d'isolation (12) selon l'une quelconque des revendications 9 à 11,
**caractérisé en ce que**
le dispositif de découplage (E₁,.., Eₙ) est réalisé comme circuit oscillant parallèle en cas d'alimentation d'un signal d'essai sinusoïdal.

13. Procédé pour déterminer une impédance de connexion transversale entre deux sous-systèmes (S₁,.., Sₙ) dans un système informatique (4) ramifié avec un système de surveillance d'isolation (12) selon l'invention selon l'une quelconque des revendications 9 à 12,
**caractérisé en ce que**
dans une mesure multiple séquentielle, chacun des deux sous-systèmes (S₁,.., Sₙ) est alimenté d'abord en le même signal d'essai, les sélectivités du dispositif de blocage et du dispositif de découplage étant réglées à être égales, ensuite chacun est alimenté avec des signaux d'essai différents, les sélectivités étant différentes, et l'impédance de connexion transversale est déterminée de la différence des valeurs de la résistance d'isolement mesurées.
